# EUROPÄISCHE PATENTANMELDUNG

(11) **EP 4 258 312 A2**
(43) Veröffentlichungstag der Anmeldung: **11.10.2023**
(21) Anmeldenummer: 23194866.2
(22) Anmeldetag: 28.04.2020
(51) Int. Cl.: H01H 13/06

(54) **TÜRENTRIEGELUNGS- UND/ODER TÜRÖFFNUNGSMECHANISMUS MIT EINER BETÄTIGUNGSVORRICHTUNG**

(30) Priorität: 02.05.2019 DE 102019206282
(62) Teilanmeldung aus: 20171843.4
(71) Anmelder: Witte Automotive GmbH, 42551 Velbert (DE)
(72) Erfinder: HOFFMANN, Andreas, 42489 Wülfrath (DE); HERDERING, Markus, 44866 Bochum (DE); SCHLOSSER, Patrick, 45219 Essen (DE); HÖHN, Ralf, 42549 Velbert (DE)
(74) Vertreter: Liedtke & Partner Patentanwälte

(57) **Zusammenfassung**

Die Erfindung betrifft einen Türentriegelungs- und/oder Türöffnungsmechanismus (2) mit einer Betätigungsvorrichtung (3), welche
- zumindest ein Betätigungselement (3.1),
- ein Gehäuse (3.2) und
- mindestens eine Erfassungseinheit (3.3) mit einem Sensor (3.3.1), einem Auslöseelement (3.3.2) und einer Auswerteeinheit (3.3.3), wobei die Erfassungseinheit (3.3) im Gehäuse (3.2) angeordnet ist, umfasst.

## Beschreibung

Die Erfindung betrifft einen Türentriegelungs- und/oder Türöffnungsmechanismus mit einer Betätigungsvorrichtung.

Türentriegelungs- und/oder Türöffnungsmechanismen sind z. B. bei Kraftfahrzeugen bekannt, bei denen ein Fahrzeugschloss einer Fahrzeugtür elektrisch entriegelt wird.

Beispielsweise wird dazu in der DE 10 2014 107 809 A1 ein Türgriff, insbesondere ein Türaußengriff eines Kraftfahrzeugs offenbart mit einem Sensor, der eine im Inneren des Türgriffs angeordnete erste Metallfläche und eine in einem Abstand dazu angeordnete zweite Metallfläche, die in Richtung der ersten Metallfläche verbiegbar ist, sowie eine Detektionseinrichtung umfasst, mittels welcher eine durch die Änderung des Abstands zwischen den Metallflächen verursachte Kapazitäts- oder Induktivitätsänderung detektierbar ist.

Weitere Zugangssysteme für ein Fahrzeug sind beispielsweise aus der DE 10 2017 120 393 A1, DE 10 2016 122 550 A1 oder US 2018/0209182 A1 bekannt.

Der Erfindung liegt die Aufgabe zu Grunde, einen gegenüber dem Stand der Technik verbesserten Türentriegelungs- und/oder Türöffnungsmechanismus, insbesondere für ein elektrisches Fahrzeugschloss, mit einer Betätigungsvorrichtung anzugeben.

Die Aufgabe wird erfindungsgemäß mit einem Türentriegelungs- und/oder Türöffnungsmechanismus gelöst, welcher die Merkmale des Anspruchs 1 aufweist.

Vorteilhafte Ausgestaltungen der Erfindung sind Gegenstand der Unteransprüche.

Erfindungsgemäß ist ein Türentriegelungs- und/oder Türöffnungsmechanismus mit einer Betätigungsvorrichtung vorgesehen, die zumindest ein Betätigungselement, ein Gehäuse und eine Erfassungseinheit mit mindestens einem Sensor, mindestens einem Auslöseelement und einer Auswerteeinheit, umfasst, wobei die Erfassungseinheit im Gehäuse angeordnet ist. Das innerhalb des Gehäuses angeordnete Auslöseelement ist in einem verriegelten Zustand des Türentriegelungs- und/oder Türöffnungsmechanismus beabstandet zum Sensor angeordnet, wobei der Sensor eine Änderung eines Abstands zwischen dem Auslöseelement und dem Sensor erfasst. Insbesondere erzeugt der Sensor ein Signal, wenn sich das Auslöseelement aufgrund der Abstandsänderung in einen Erfassungsbereich des Sensors bewegt. Der Sensor verhält sich hierbei als eine feste Elektrode, insbesondere Messelektrode, und das Auslöseelement als bewegliche Elektrode, insbesondere Referenzelektrode. Die Auswerteeinheit wertet das Sensorsignal aus und übermittelt ein Öffnungssignal an den Türentriegelungs- und/oder Türöffnungsmechanismus, wenn diese anhand der vom Sensor erfassten Abstandsänderung eine Abstandsverringerung zwischen dem Auslöseelement und dem Sensor ermittelt.

Die derart ausgebildete Betätigungsvorrichtung ermöglicht eine kompakte Bauweise, die gegenüber konventionellen Betätigungsvorrichtungen weniger Bauraum erfordert. Dabei ist aufgrund der Anordnung der Erfassungseinheit innerhalb des Gehäuses ein Öffnen desselben, beispielsweise für eine Schalterbetätigung wie bei bekannten Betätigungsvorrichtungen, nicht erforderlich. Das Gehäuse ist somit gegenüber äußeren Einflüssen abgedichtet. Ferner ermöglicht der Türentriegelungs- und/oder Türöffnungsmechanismus eine schalterlose Bedieneinheit zur elektrischen Öffnung einer Tür, so dass ein Verschleiß der Betätigungsvorrichtung gegenüber schalterbasierten Betätigungsvorrichtungen verringert ist.

Gemäß einem Ausführungsbeispiel ist das Auslöseelement elastisch verformbar ausgebildet. Insbesondere ist das Auslöseelement ein Blech, beispielsweise eine Blechzunge oder Blechlasche. Damit kann das Auslöseelement bei Krafteinwirkung, insbesondere bei Betätigung des Betätigungselements, elastisch deformiert werden. Aus der elastischen Deformation resultiert eine Abstandsänderung, die vom Sensor erfasst wird. Die Abstandsänderung zwischen dem Auslöseelement und dem Sensor kann auch eine bereichsweise Abstandsänderung zwischen dem Auslöseelement und dem Sensor umfassen. Mit anderen Worten: Das Auslöseelement wird nur in einem bestimmten Bereich in Richtung des Sensors deformiert, so dass sich ein Abstand auch nur zwischen diesem Bereich des Auslöseelements und dem Sensor ändert. Alternativ kann das Auslöseelement auch aus einem nicht-metallischen, elastisch verformbaren Werkstoff gebildet sein.

Gemäß einem weiteren Ausführungsbeispiel ist das Gehäuse ein einteiliges Kunststoffgehäuse. Dies ermöglicht eine optimale Abdichtung des Gehäuses gegenüber äußeren Einflüssen. Die innerhalb des Gehäuses angeordnete Erfassungseinheit ist somit geschützt. Eine Öffnung des Gehäuses ist aufgrund der schalterlosen Ausbildung der Betätigungsvorrichtung nicht erforderlich.

Beispielsweise weist das Gehäuse eine das Auslöseelement verdeckende Gehäuseseite, insbesondere Gehäusewand, auf, die elastisch verformbar ausgebildet ist. Dies ermöglicht eine Kraftübertragung vom Gehäuse auf das Auslöseelement bei Betätigung des Betätigungselements. Beispielsweise ist eine Wandstärke dieser Gehäuseseite geringer als bei anderen Gehäuseseiten, so dass eine Elastizität des Gehäuses in diesem Bereich erhöht ist. Alternativ oder zusätzlich kann der Kunststoff in diesem Bereich auch mit einem elastischen Material versehen sein, welcher entweder kovalent in den Kunststoff eingebunden ist oder äußerlich mit dem Kunststoff in Wechselwirkung tritt. Ferner kann die elastische Gehäuseseite auch aus einem anderen Material wie das restliche Gehäuse bestehen, so dass dieses nicht einteilig, sondern zweiteilig oder mehrteilig ausgebildet ist.

Gemäß einem weiteren Ausführungsbeispiel ist das Betätigungselement an der elastischen Gehäuseseite angeordnet. Dies ermöglicht eine Kraftübertragung in Betätigungsrichtung vom Betätigungselement auf das Gehäuse und somit auf das Auslöseelement. Das Betätigungselement weist insbesondere in einem Betätigungsbereich eine wertige Kunststoffoberfläche auf, mittels welcher das Betätigungselement eine mechanische Stabilität, einen Korrosionsschutz und eine ansprechende Optik aufweist.

Gemäß einem weiteren Ausführungsbeispiel ist der Sensor ein kapazitiver Sensor, so dass die Abstandsänderung zwischen dem Sensor und dem Auslöseelement anhand einer Kapazitätsänderung zwischen dem Auslöseelement und dem Sensor, welche hierbei einen Plattenkondensator bilden, erfasst wird. Der Sensor erzeugt dabei in Abhängigkeit einer Änderung der Kapazität ein Sensorsignal zur Auswertung. Des Weiteren kann das Auslöseelement beispielsweise mit einem elektrischen Nullpotential verbunden und elektrisch schaltbar an die Auswerteeinheit gekoppelt sein. Dies ermöglicht eine zeitlich abwechselnde Auswertung einer zwischen dem Auslöseelement und dem Sensor erfassten Kapazität sowie eine Auswertung einer mittels einer erfassten Kapazität des Auslöseelements gegenüber dem elektrischen Nullpotential. Letzteres dient insbesondere zur Erfassung einer Annäherung eines Objekts, insbesondere einer Hand eines Nutzers, an das Betätigungselement.

In einem alternativen Ausführungsbeispiel ist der Sensor ein induktiver Sensor, insbesondere ein sogenannter inductance to digital converter (LDC)-Sensor. Hierbei wird die Abstandsänderung aufgrund einer Frequenzverschiebung eines Schwingkreises des Sensors erfasst; die aus der Abstandsänderung zwischen dem Auslöseelement und dem Sensor resultiert. Der Sensor umfasst dazu einen Oszillator, welcher mittels eines Schwingkreises ein elektromagnetisches Wechselfeld erzeugt, das aus einer aktiven Fläche des Sensors austritt. Ein derartiger induktiver Sensor ermöglicht eine besonders hohe Empfindlichkeit, wobei die Frequenzverschiebung des Schwingkreises einfach erfasst werden kann.

Insbesondere basiert die Erfassungseinheit auf der sogenannten Metal over Cap (kurz: MoC) Technologie, bei welcher der Sensor von äußeren Einflüssen abgeschirmt ist. Eine Hand oder ein Finger eines Nutzers im Erfassungsbereich des Sensors wird hierbei durch das Auslöseelement ersetzt. Dies ermöglicht die Sensierung auch von Mikrobewegungen. Zudem ist die Erfassungseinheit robust gegenüber Vibrationen und temperaturbeständig.

Zur automatischen Rückstellung des Betätigungselements in eine Initialposition, insbesondere in eine Nicht-Betätigungsposition, kann zwischen dem Betätigungselement und dem Gehäuse mindestens ein Rückstellelement angeordnet sein. Das Rückstellelement ist gemäß einem Ausführungsbeispiel ein geschlossen-poriger Schaum, z. B. ein Weichschaum aus Polyurethan. Das Rückstelleelement zeichnet sich hierbei durch eine gute Kompressibilität aus, die eine schnelle und verschleißarme Rückstellung des Betätigungselements ermöglicht.

Des Weiteren umfasst der Türentriegelungs- und/oder Türöffnungsmechanismus ein Türschloss und eine Steuereinheit. Beispielsweise weist der Türentriegelungs-und/oder Türöffnungsmechanismus folgende Funktionen auf:
- die Auswerteeinheit der Betätigungsvorrichtung übermittelt ein Öffnungssignal an die Steuereinheit, wenn die Auswerteeinheit anhand der vom Sensor erfassten Position eine Abstandsänderung, insbesondere eine Abstandsverringerung, zwischen dem Auslöseelement und dem Sensor ermittelt und
- die Steuereinheit des Türentriegelungs- und/oder Türöffnungsmechanismus generiert anhand des Öffnungssignals ein Steuersignal und übermittelt dieses zur Entriegelung des Türschlosses an das Türschloss.

Bei dem derart ausgebildeten Türentriegelungs- und/oder Türöffnungsmechanismus kann eine Auslöseschwelle zur Übermittlung des Öffnungssignals individuell festgelegt werden. Der Türentriegelungs- und/oder Türöffnungsmechanismus kann somit an Wünsche und/oder Vorgaben eines Herstellers individuell angepasst werden.

Der Türentriegelungs- und/oder Türöffnungsmechanismus ist insbesondere für eine Fahrzeugtür vorgesehen, welche beispielsweise eine Fahrzeugseitentür und/oder eine Fahrzeugheckklappe ist.

Gemäß einem weiteren Ausführungsbeispiel kann die Betätigungsvorrichtung im Bereich eines Türaußengriffes angeordnet sein. Beispielsweise ist die Betätigungsvorrichtung an einer Außenseite des Türaußengriffes oder an einer dem Fahrzeug zugewandten Seite des Türaußengriffes angeordnet.

Alternativ kann die Betätigungsvorrichtung in einer in der Fahrzeugaußenhaut eingebrachten Eingriffsmulde angeordnet sein. Die Eingriffsmulde kann in einem beliebigen Bereich der Fahrzeugaußenhaut angeordnet sein. Beispielsweise ist die Eingriffsmulde in einem Bereich einer Fahrzeugaußenhaut der Fahrzeugtür, welche dem Türaußengriff zugewandt ist, angeordnet. Aufgrund des geringen Bauraumbedarfs der Betätigungsvorrichtung kann eine Anordnungsposition der Betätigungsvorrichtung in der Fahrzeugtür an Wünsche und/oder Vorgaben eines Herstellers individuell angepasst werden.

Ausführungsbeispiele der Erfindung werden im Folgenden anhand von Zeichnungen näher erläutert.

Darin zeigen:
- Figur 1: ein Blockschaltbild mit einer Fahrzeugtür, umfassend einen Türentriegelungs- und/oder Türöffnungsmechanismus mit einer Betätigungsvorrichtung, einem Türschloss und einer Steuereinheit,
- Figur 2: ein Blockschaltbild mit einer Fahrzeugtür und der Betätigungsvorrichtung im Bereich eines Türaußengriffs,
- Figur 3: ein Blockschaltbild mit einer Fahrzeugtür und der Betätigungsvorrichtung im Bereich einer Eingriffsmulde,
- Figur 4: schematisch eine perspektivische Ansicht einer Betätigungsvorrichtung für einen Türentriegelungs- und/oder Türöffnungsmechanismus,
- Figur 5: schematisch eine perspektivische Ansicht einer Erfassungseinheit der Betätigungsvorrichtung, und
- Figur 6: schematisch eine Draufsicht auf die Erfassungseinheit gemäß Figur 5.

Einander entsprechende Teile sind in allen Figuren mit den gleichen Bezugszeichen versehen.

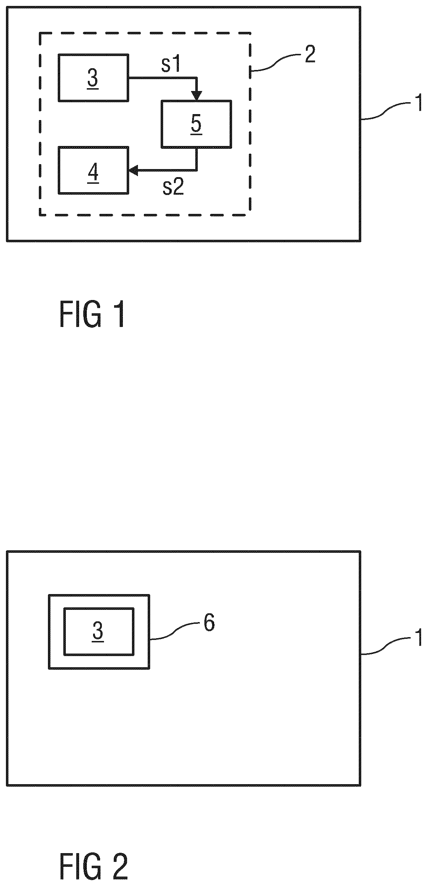

**Figur 1** zeigt ein Blockschaltbild mit einer Fahrzeugtür 1, die einen Türentriegelungs- und/oder Türöffnungsmechanismus 2 umfasst.

Die Fahrzeugtür 1 ist Bestandteil eines nicht näher gezeigten Fahrzeugs und beispielsweise eine Fahrzeugseitentür oder eine Fahrzeugheckklappe. Zum Öffnen der Fahrzeugtür 1 weist diese den Türentriegelungs- und/oder Türöffnungsmechanismus 2 auf.

Der Türentriegelungs- und/oder Türöffnungsmechanismus 2 umfasst eine Betätigungsvorrichtung 3, ein Türschloss 4, insbesondere ein elektrisch ansteuerbares Türschloss 4, und eine Steuereinheit 5.

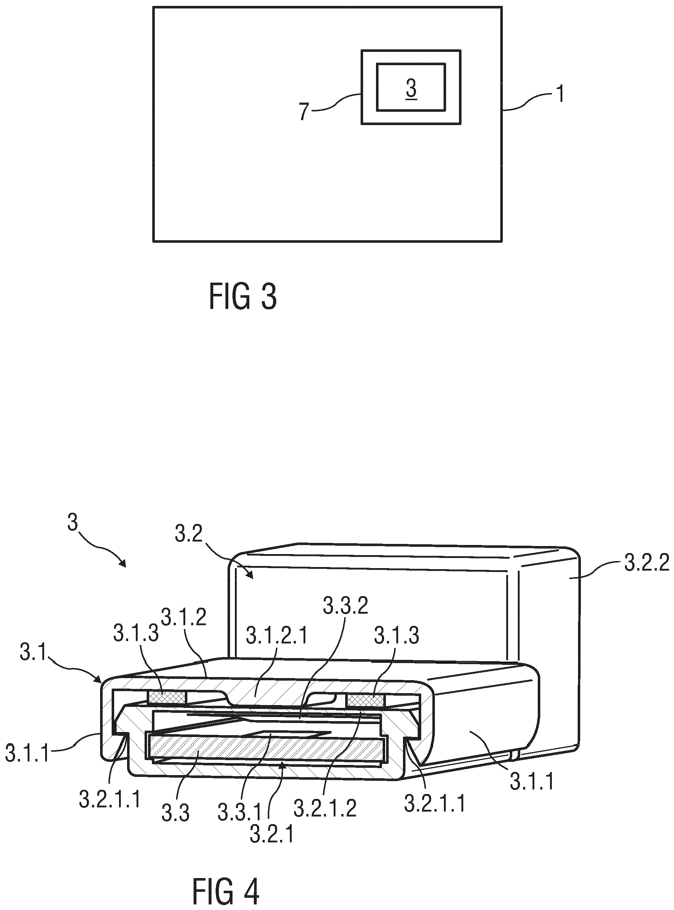

Die Betätigungsvorrichtung 3 ist in den **Figuren 4 bis 6** näher dargestellt und beschrieben. Die Betätigungseinheit 3 ist insbesondere dazu vorgesehen, eine Betätigung zur Entriegelung und zum Öffnen der Fahrzeugtür 1 zu erfassen und dies an die Steuereinheit 5 zu übermitteln. Insbesondere übermittelt die Betätigungsvorrichtung 3 ein Öffnungssignal s1 an die Steuereinheit 5, welche in Abhängigkeit davon ein Steuersignal s2 an das Türschloss 4 übermittelt, welches daraufhin entriegelt, so dass die Fahrzeugtür 1 geöffnet werden kann.

**Figur 2** zeigt ein Blockschaltbild mit einer Fahrzeugtür 1 und der Betätigungsvorrichtung 3, welche im Bereich eines Türaußengriffs 6 angeordnet ist. Beispielsweise ist die Betätigungsvorrichtung 3 an einer Außenseite des Türaußengriffes 6 oder an einer der Fahrzeugtür 1 zugewandten Seite des Türaußengriffes 6 angeordnet.

**Figur 3** zeigt ein Blockschaltbild mit einer alternativen Anordnung der Betätigungsvorrichtung 3 in der Fahrzeugtür 1. Hierbei ist die Betätigungsvorrichtung 3 im Bereich einer Eingriffsmulde 7 angeordnet, welche in die Fahrzeugaußenhaut der Fahrzeugtür 1 eingebracht ist. Die Eingriffsmulde 7 kann in einem beliebigen Bereich der Fahrzeugaußenhaut angeordnet sein. Beispielsweise ist die Eingriffsmulde in einem Bereich der Fahrzeugaußenhaut der Fahrzeugtür 1 angeordnet, welche dem Türaußengriff 6 gegenüberliegt.

**Figur 4** zeigt eine perspektivische Ansicht der Betätigungsvorrichtung 3.

Die Betätigungsvorrichtung 3 umfasst ein Betätigungselement 3.1, ein Gehäuse 3.2 und eine Erfassungseinheit 3.3.

Das Betätigungselement 3.1 ist außerhalb des Gehäuses 3.2 und in einem für einen Nutzer sichtbaren oder zumindest mit einer Hand erreichbaren Bereich der Fahrzeugtür 1 zur Betätigung angeordnet.

Das Betätigungselement 3.1 ist im Wesentlichen plattenförmig ausgebildet, wobei das Betätigungselement 3.1 im gezeigten Ausführungsbeispiel einen im Wesentlichen U-förmigen Querschnitt aufweist. Die seitlichen Schenkel werden dabei durch abgewinkelte Randbereiche 3.1.1 gebildet. Der mittlere Schenkel wird durch eine die abgewinkelten Randbereiche 3.1.1 miteinander verbindenden und im Wesentlichen parallel zu einem elastischen Gehäusebereich 3.2.1 verlaufenden Betätigungsplatte 3.1.2 gebildet. Die abgewinkelten Randbereiche 3.1.1 des Betätigungselements 3.1 umgreifen dabei den elastischen Gehäusebereich 3.2.1 randseitig. Offene Enden der abgewinkelten Randbereiche 3.1.1 sind dazu jeweils hakenförmig ausgebildet und greifen formschlüssig in einen außenseitig, insbesondere außenrandseitig, in einen in den elastischen Gehäusebereich 3.2.1 eingebrachten Hinterschnitt 3.2.1.1 ein.

Die Betätigungsplatte 3.1.2 liegt mit einer mittig angeordneten Verstärkung 3.1.2.1 auf dem elastischen Gehäusebereich 3.2.1 auf, so dass eine Kraft von der Betätigungsplatte 3.1.2 auf den elastischen Gehäusebereich 3.2.1 übertragbar ist. Die Verstärkung 3.1.2.1 ist durch eine Verdickung einer Wandstärke der Betätigungsplatte 3.1.2 gebildet.

In Bereichen jeweils neben der Verstärkung 3.1.2.1 ist die Betätigungsplatte 3.1.2 beabstandet zum elastischen Gehäusebereich 3.2.1 angeordnet. In dadurch gebildete Zwischenräume ist jeweils ein Rückstellelement 3.1.3 angeordnet. Das Rückstellelement 3.1.3 ermöglicht eine Rückstellung des Betätigungselements 3.1 in eine Initialposition wie gezeigt, die insbesondere einer Nicht-Betätigungsposition entspricht. Das Rückstellelement 3.1.3 ist beispielsweise ein geschlossen-poriger Schaum, z. B. ein Weichschaum aus Polyurethan. Im gezeigten Ausführungsbeispiel sind zwischen dem elastischen Gehäusebereich 3.2.1 und der Betätigungsplatte 3.1.2 zwei Rückstellelemente 3.1.3 angeordnet.

Das Betätigungselement 3.1 weist ferner zumindest im Bereich der Betätigungsplatte 3.1.2, insbesondere auf einer dem Gehäuse 3.2 abgewandten Seite, eine wertige Kunststoffoberfläche auf, mittels welcher das Betätigungselement 3.1 eine mechanische Stabilität, einen Korrosionsschutz und eine ansprechende Optik aufweist.

Das Gehäuse 3.2 umschließt die Erfassungseinheit 3.3 und ist beispielsweise ein einteiliges Kunststoffgehäuse. Dies ermöglicht eine optimale Abdichtung des Gehäuses 3.2 gegenüber äußeren Einflüssen. Die innerhalb des Gehäuses 3.2 angeordnete Erfassungseinheit 3.3 ist somit geschützt.

Gemäß dem vorliegenden Ausführungsbeispiel weist das Gehäuse 3.2 den elastischen Gehäusebereich 3.2.1 und einen dazu abgewinkelten starren Gehäusebereich 3.2.2 auf. Beide Gehäusebereiche 3.2.1, 3.2.2 bilden eine L-Form, wobei der starre Gehäusebereich 3.2.2 den in Blickrichtung senkrechten Schenkel und der elastische Gehäusebereich 3.2.1 den in Blickrichtung waagerechten Schenkel bildet.

Der starre Gehäusebereich 3.2.2 dient insbesondere einer Befestigung der Betätigungsvorrichtung 3 in der Fahrzeugtür 1. Der elastische Gehäusebereich 3.2.1 dient einer Kraftübertragung von der Betätigungsplatte 3.1.2 auf die Erfassungseinheit 3.3 und ist dahingehend elastisch ausgebildet, dass dieser eine elastische Gehäuseseite 3.2.1.2 aufweist, die parallel zur Betätigungsplatte 3.1.2 verläuft.

Zur elastischen Ausbildung ist diese Gehäuseseite 3.2.1.2 beispielsweise mit einer verringerten Wandstärke gegenüber anderen Gehäuseseiten ausgebildet. Alternativ oder zusätzlich kann der Werkstoff, insbesondere der Kunststoff, in diesem Bereich auch mit einem elastischen Material versehen sein, welcher entweder kovalent in den Werkstoff eingebunden ist oder äußerlich mit dem Werkstoff in Wechselwirkung tritt. Ferner kann die elastische Gehäuseseite 3.2.1.2 auch aus einem anderen Material wie das restliche Gehäuse 3.2 bestehen, so dass dieses nicht einteilig, sondern zweiteilig oder mehrteilig ausgebildet ist.

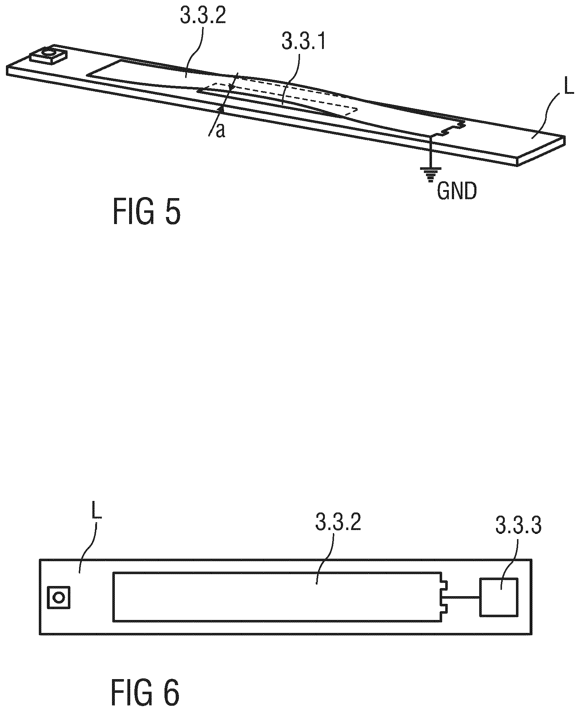

Die im Gehäuse 3.2 angeordnete Erfassungseinheit 3.3 umfasst einen Sensor 3.3.1, ein Auslöseelement 3.3.2 und eine Auswerteeinheit 3.3.3. Der innerhalb des Gehäuses 3.2 angeordnete Sensor 3.3.1 bildet hierbei insbesondere eine feste Elektrode und das ebenfalls innerhalb des Gehäuses 3.2 angeordnete Auslöseelement 3.3.2 eine zur festen Elektrode bewegliche Elektrode. Die Auswerteeinheit 3.3.3 dient einer Ermittlung einer Betätigung des Betätigungselements, auf welche bei einer ermittelten Abstandsverringerung zwischen dem Sensor 3.3.1 und dem Auslöseelement 3.3.2 geschlossen wird, und ist gemäß dem gezeigten Ausführungsbeispiel in **Figur 5 und 6** ein integraler Bestandteil einer Leiterplatte L, auf welcher ebenso der Sensor 3.3.1 angeordnet, insbesondere befestigt, ist.

Der Sensor 3.3.1 ist beispielsweise ein kapazitiver Sensor, welcher eine Abstandsänderung zwischen dem Sensor 3.3.1 und dem Auslöseelement 3.3.2 anhand einer Kapazitätsänderung zwischen diesen erfasst. Der Sensor 3.3.1 und das Auslöseelement 3.3.2 verhalten sich dabei wie ein idealer Plattenkondensator. Insbesondere erzeugt der Sensor 3.3.1 in Abhängigkeit einer Änderung der Kapazität ein Sensorsignal, welches von der Auswerteeinheit 3.3.3 ausgewertet wird.

Alternativ ist der Sensor 3.3.1 ein induktiver Sensor, welcher auf der sogenannten inductance to digital converter (LDC)-Technologie basiert. Hierbei wird die Abstandsänderung zwischen dem Sensor 3.3.1 und dem Auslöseelement 3.3.2 aufgrund einer Frequenzverschiebung eines Schwingkreises des Sensors 3.3.1 erfasst. Beispielsweise umfasst der Sensor 3.3.1 dazu einen Oszillator (nicht gezeigt), welcher mittels eines Schwingkreises ein elektromagnetisches Wechselfeld erzeugt, das aus einer aktiven Fläche des Sensors 3.3.1 austritt. Das vom Sensor 3.3.1 in Abhängigkeit der erfassten Frequenzverschiebung erzeugte Signal wird beispielsweise in ein digitales Signal umgewandelt und von der Auswerteeinheit 3.3.3 ausgewertet.

Das Auslöseelement 3.3.2 ist in einem verriegelten Zustand des Türentriegelungs- und/oder Türöffnungsmechanismus 2 innerhalb des Gehäuses 3.2 in einem vorgegebenen Abstand a zum Sensor 3.3.1 angeordnet und wird von der elastischen Gehäuseseite 3.2.1.2 verdeckt. Das Auslöseelement 3.3.2 ist elastisch verformbar und beispielsweise ein Blech, insbesondere eine Blechzunge oder Blechlasche. Alternativ kann das Auslöseelement 3.3.2 auch aus einem nicht-metallischen, elastisch verformbaren Werkstoff gebildet sein.

Des Weiteren ist das Auslöseelement 3.3.2 jeweils stirnendseitig an der Leiterplatte L befestigt. Beispielsweise ist das Auslöseelement 3.3.2 mit der Leiterplatte L verschraubt und/oder verschweißt und/oder verlötet. Das Auslöseelement 3.3.2 erstreckt sich somit im Wesentlichen halbkreisförmig über dem Sensor 3.3.1, wobei ein Abstand zwischen dem Auslöseelement 3.3.2 und der Leiterplatte L in einer Mitte des Auslöseelements 3.3.2 am größten ist. In diesem Bereich ist der Sensor 3.3.1 auf der Leiterplatte L angeordnet.

Die beschriebene Elastizität, Anordnung und Befestigung des Auslöseelements 3.3.2 ermöglichen eine Deformation des Auslöseelements 3.3.2 im mittleren Bereich bei Krafteinwirkung, insbesondere bei Betätigung des Betätigungselements 3.1, in Richtung des Sensors 3.3.1. Die Deformation des Auslöseelements 3.3.2 findet dabei in einem Mikrometer- bis Millimeterbereich, z. B. zwischen 0,1 Millimeter und 10 Mikrometer, statt.

Im gezeigten Ausführungsbeispiel ist das Auslöseelement 3.3.2 weiterhin mit einem elektrischen Nullpotential GND verbunden und somit geerdet. Ferner ist das Auslöseelement 3.3.2 elektrisch schaltbar an die Auswerteeinheit 3.3.3 gekoppelt. Dies ermöglicht eine zeitlich abwechselnde Auswertung beispielsweise einer Kapazität zwischen dem Auslöseelement 3.3.2 und dem Sensor 3.3.1 sowie eine Auswertung einer Kapazität zwischen dem Auslöseelement 3.3.2 und dem elektrischen Nullpotential GND. Letzteres dient insbesondere zur Erfassung einer Annäherung eines Objekts, insbesondere einer Hand eines Nutzers, an das Betätigungselement 3.1. Dies kann als zusätzliche Absicherung einer Türöffnungsanforderung verwendet werden. Damit ist mittels der Betätigungsvorrichtung 3 gleichzeitig eine Annäherung an das Betätigungselement 3.1 als auch eine mechanische Betätigung des Betätigungselements 3.1 erkennbar. Eine Funktion "Elektronikschloss-Öffnung" und eine Funktion "Fahrzeug-Entriegelung" sind somit innerhalb der gleichen Funktionsfläche durchführbar.

Alternativ kann die Erfassungseinheit 3.3 auch derart ausgebildet sein, dass nur eine Betätigung des Betätigungselements 3.1 erfasst wird.

Die Betätigungsvorrichtung 3 weist eine besonders kompakte Bauweise auf, wobei aufgrund der Anordnung der Erfassungseinheit 3.3 innerhalb des Gehäuses 3.2 ein Öffnen des Gehäuses 3.2 nicht erforderlich ist und die Erfassungseinheit 3.3 vor äußeren Einflüssen geschützt ist.

Alternativ können als Erfassungseinheit 3.3 auch Schnappscheiben-Schalter verwendet werden. Schnappscheibenschalter sind rein mechanisch und ermöglichen eine haptische Rückmeldung.

Die **Figuren 5 bis 6** zeigen die Erfassungseinheit 3.3 in verschiedenen Ansichten. Die Erfassungseinheit 3.3 ist in **Figur 5** in einer perspektivischen Ansicht und in **Figur 6** in einer Draufsicht gezeigt.

Im Folgenden wird ein beispielhafter Ablauf des Türentriegelungs- und/oder Türöffnungsmechanismus 2 beschrieben: Ein Nutzer nähert sich der Fahrzeugtür 1 mit dem Wunsch, diese zu öffnen. Das Türschloss 4 der Fahrzeugtür 1 ist verriegelt. Zum Öffnen der Fahrzeugtür 1 nähert sich eine Hand des Nutzers der Betätigungsvorrichtung 3. Die Erfassungseinheit 3.3.1 erfasst die Annäherung der Hand des Nutzers durch Erfassen der Kapazität zwischen dem Auslöseelement 3.3.2 und dem elektrischen Nullpotential GND. Anschließend betätigt der Nutzer das Betätigungselement 3.1, in dem dieser auf die Betätigungsplatte 3.1.2 einen Druck ausübt. Dieser Druck wird von der Betätigungsplatte 3.1.2 auf die elastische Gehäuseseite 3.2.1.2 übertragen, welche wiederum den Druck durch Verformung auf das Auslöseelement 3.3.2 überträgt. Das Auslöseelement 3.3.2 deformiert sich in Richtung des Sensors 3.3.1, welcher daraufhin eine Kapazitätsänderung erfasst und ein Sensorsignal erzeugt und an die Auswerteeinheit 3.3.3 übermittelt. Die Auswerteeinheit 3.3.3 wertet das Sensorsignal aus und erkennt eine Betätigung des Betätigungselements 3.1. Daraufhin generiert die Auswerteeinheit 3.3.3 ein Öffnungssignal s1 und übermittelt dieses an die Steuereinheit 5. Die Steuereinheit 5 erkennt anhand des Öffnungssignals s1 einen Öffnungswunsch eines Nutzers und generiert ein Steuersignal s2, welches an das Türschloss 4 übermittelt wird und welches daraufhin entriegelt wird. Die Fahrzeugtür 1 kann nun vom Nutzer geöffnet werden. Die Betätigungsplatte 3.1.2 wird mittels der Rückstellelemente 3.1.3 in seine Initialposition zurück bewegt. Dadurch wirkt auf die elastische Gehäuseseite 3.2.1.2 und somit auf das Auslöseelement 3.3.2 kein Druck mehr, so dass diese ebenfalls in eine Initialposition zurück bewegt werden.

### BEZUGSZEICHENLISTE

- 1: Fahrzeugtür
- 2: Türentriegelungs- und/oder Türöffnungsmechanismus
- 3: Betätigungsvorrichtung
- 3.1: Betätigungselement
- 3.1.1: abgewinkelter Randbereich
- 3.1.2: Betätigungsplatte
- 3.1.2.1: Verstärkung
- 3.1.3: Rückstellelement
- 3.2: Gehäuse
- 3.2.1: elastischer Gehäusebereich
- 3.2.1.1: Hinterschnitt
- 3.2.1.2: elastische Gehäuseseite
- 3.2.2: starrer Gehäusebereich
- 3.3: Erfassungseinheit
- 3.3.1: Sensor
- 3.3.2: Auslöseelement
- 3.3.3: Auswerteeinheit
- 4: Türschloss
- 5: Steuereinheit
- 6: Türaußengriff
- 7: Eingriffsmulde

- GND: elektrisches Nullpotential
- L: Leiterplatte

- a: Abstand
- s1: Öffnungssignal
- s2: Steuersignal

## Patentansprüche

1. Türentriegelungs- und/oder Türöffnungsmechanismus (2) mit einer Betätigungsvorrichtung (3), welche
- zumindest ein Betätigungselement (3.1),
- ein Gehäuse (3.2) und
- mindestens eine Erfassungseinheit (3.3) mit einem Sensor (3.3.1), einem Auslöseelement (3.3.2) und einer Auswerteeinheit (3.3.3), wobei die Erfassungseinheit (3.3) im Gehäuse (3.2) angeordnet ist,
umfasst,
wobei das Betätigungselement (3.1) außerhalb des Gehäuses (3.2) und in einem von außen erreichbaren Bereich für eine Betätigung angeordnet ist,
wobei das Auslöseelement (3.3.2) in einem verriegelten Zustand des Türentriegelungs- und/oder Türöffnungsmechanismus (2) beabstandet zum Sensor (3.3.1) angeordnet ist,
wobei bei einer Betätigung des Betätigungselements (3.1) in Richtung des Gehäuses (3.2) und des darin angeordneten Sensors (3.3.1) das Betätigungselement (3.1) das Auslöseelement (3.3.2) deformiert, und wobei der Sensor (3.3.1) eine Änderung eines Abstands (a) zwischen dem Auslöseelement (3.3.2) und dem Sensor (3.3.1) erfasst und
wobei die Auswerteeinheit (3.3.3) ein Öffnungssignal (s1) an den Türentriegelungs- und/oder Türöffnungsmechanismus (2) übermittelt, wenn diese anhand der vom Sensor (3.3.1) erfassten Abstandsänderung eine Abstandsverringerung zwischen dem Auslöseelement (3.3.2) und dem Sensor (3.3.1) ermittelt, wobei die Auswerteeinheit (3.3.3) integraler Bestandteil einer Leiterplatte (L) ist, auf welcher ebenso der Sensor (3.3.1) angeordnet ist.

2. Türentriegelungs- und/oder Türöffnungsmechanismus (2) nach Anspruch 1, wobei das Auslöseelement (3.3.2) stirnendseitig an der Leiterplatte (L) befestigt ist und sich im Wesentlichen halbkreisförmig über dem Sensor (3.3.1) erstreckt.

3. Türentriegelungs- und/oder Türöffnungsmechanismus (2) nach Anspruch 2,
wobei ein Abstand zwischen dem Auslöseelement (3.3.2) und der Leiterplatte (L) in einer Mitte des Auslöseelements (3.3.2), in dem der Sensor (3.3.1) auf der Leiterplatte (L) angeordnet ist, am größten ist.

4. Türentriegelungs- und/oder Türöffnungsmechanismus (2) nach einem der vorhergehenden Ansprüche, wobei das Auslöseelement (3.3.2) mit einem elektrischen Nullpotential (GND) zur Erfassung einer Annäherung eines Objekts an das Betätigungselement (3.1) verbunden und elektrisch schaltbar an die Auswerteeinheit (3.3.3) gekoppelt ist.

5. Türentriegelungs- und/oder Türöffnungsmechanismus (2) nach Anspruch 4,
wobei die Auswerteeinheit (3.3.3) ausgebildet ist, eine zeitlich abwechselnde Auswertung einer Kapazität zwischen dem Auslöseelement (3.3.2) und dem Sensor (3.3.1) sowie eine Auswertung einer Kapazität zwischen dem Auslöseelement (3.3.2) und dem elektrischen Nullpotential (GND) durchzuführen.

6. Türentriegelungs- und/oder Türöffnungsmechanismus (2) nach einem der vorhergehenden Ansprüche, wobei das Auslöseelement (3.3.2) elastisch verformbar ausgebildet ist.

7. Türentriegelungs- und/oder Türöffnungsmechanismus (2) nach einem der vorhergehenden Ansprüche, wobei das Gehäuse (3.2) ein einteiliges Kunststoffgehäuse ist.

8. Türentriegelungs- und/oder Türöffnungsmechanismus (2) nach einem der vorhergehenden Ansprüche, wobei das Gehäuse (3.2) eine das Auslöseelement (3.2) verdeckende elastische Gehäuseseite (3.2.1.2) aufweist.

9. Türentriegelungs- und/oder Türöffnungsmechanismus (2) nach Anspruch 8,
wobei das Betätigungselement (3.1) an der elastischen Gehäuseseite (3.2.1.2) angeordnet ist.

10. Türentriegelungs- und/oder Türöffnungsmechanismus (2) nach einem der vorhergehenden Ansprüche, wobei der Sensor (3.3.1) ein kapazitiver Sensor ist.

11. Türentriegelungs- und/oder Türöffnungsmechanismus (2) nach einem der Ansprüche 1 bis 3, wobei der Sensor (3.3.1) ein induktiver Sensor ist.

12. Türentriegelungs- und/oder Türöffnungsmechanismus (2) nach einem der vorhergehenden Ansprüche, wobei zwischen dem Betätigungselement (3.1) und dem Gehäuse (3.2) mindestens ein Rückstellelement (3.1.3) zur Rückstellung des Betätigungselements (3.1) angeordnet ist.

13. Türentriegelungs- und/oder Türöffnungsmechanismus (2) nach Anspruch 12,
wobei das Rückstellelement (3.1.3) ein geschlossen-poriger Schaum ist.
